# EUROPEAN PATENT APPLICATION

(11) **EP 4 538 760 A1**
(43) Date of publication of application: **16.04.2025**
(21) Application number: 23865680.5
(22) Date of filing: 29.06.2023
(51) Int. Cl.: G02B 6/122, H05K 1/02, H05K 3/28

(54) **OPTICAL COMMUNICATION DEVICE USING CONFORMAL COATING LAYER AS OPTICAL WAVEGUIDE**

(30) Priority: 16.09.2022 KR 20220117485
(71) Applicant: LG Energy Solution, Ltd., Seoul 07335 (KR)
(72) Inventor: YU, Jae Wook, Daejeon 34122 (KR)
(74) Representative: Plasseraud IP
(86) International application number: PCT/KR2023/009173
(87) International publication number: WO 2024/058376

(57) **Abstract**

An optical communication device according to an embodiment disclosed herein includes a first optical element, a second optical element capable of performing optical communication with the first optical element, a printed circuit board (PCB) where the first optical element and the second optical element are arranged, and a first conformal coating layer of a polymer material, coated onto at least a part of a surface of the PCB, in which the optical communication is performed using the first conformal coating layer as an optical waveguide.

## Description

### [TECHNICAL FIELD]

### CROSS-REFERENCE TO RELATED APPLICATION

This application claims priority to and the benefit of Korean Patent Application No. 10-2022-0117485 filed in the Korean Intellectual Property Office on September 16, 2022, the entire contents of which are incorporated herein by reference.

### TECHNICAL FIELD

Embodiments disclosed herein relate to an optical communication device using a conformal coating layer as an optical waveguide.

### [BACKGROUND ART]

With the recent advancement of autonomous driving and advanced driver assistance systems (ADAS), bandwidth increase and integrity of data are required and data integrity and electromagnetic compatibility (EMC) issues are encountered. Consequently, optical communication technology has been introduced, which is capable of replacing standards such as a local interconnect network (LIN), a controller area network (CAN), a controller area network flexible data-rate (CAN FD), and FlexRay, etc., conventionally used for vehicle communication.

When the optical communication technology, which is a means for quick signal transmission between components of an electronic device, is applied to the electronic device, signal transmission may be performed at higher speeds, and disadvantages of existing signal transmission methods, such as high resistance, high heat generation, and parasitic capacitance, may be alleviated.

### [DISCLOSURE]

### [TECHNICAL PROBLEM]

Conventionally, optical cables have been used as optical waveguides for optical communication. However, for the optical cables, due to their high cost and flexibility, it is not free to secure a line of sight (LoS) of a component for transmitting and receiving an optical communication signal, resulting in limitations in use for short-range communication inside vehicles.

Embodiments disclosed herein aim to provide an optical communication device that uses, as an optical waveguide for optical communication, a conformal coating layer of a printed circuit board (PCB) where optical elements are arranged.

Technical problems of the embodiments disclosed herein are not limited to the above-described technical problems, and other unmentioned technical problems would be clearly understood by one of ordinary skill in the art from the following description.

### [TECHNICAL SOLUTION]

An optical communication device according to an embodiment disclosed herein includes a first optical element, a second optical element capable of performing optical communication with the first optical element, a printed circuit board (PCB) where the first optical element and the second optical element are arranged, and a first conformal coating layer of a polymer material, coated onto at least a part of a surface of the PCB, in which the optical communication is performed using the first conformal coating layer as an optical waveguide.

In the optical communication device according to an embodiment disclosed herein, the first conformal coating layer may be configured to contact an optical signal input/output unit of the first optical element and an optical signal input/output unit of the second optical element.

In the optical communication device according to an embodiment disclosed herein, the first conformal coating layer may be configured to avoid contacting optical elements other than the first optical element and the second optical element among a plurality of optical elements arranged on the PCB.

In the optical communication device according to an embodiment disclosed herein, the first conformal coating layer may include a material that allows an optical signal traveling inside the first conformal coating layer to be totally reflected from a surface of the first conformal coating layer.

In the optical communication device according to an embodiment disclosed herein, a refractive index of the first conformal coating layer may be greater than a refractive index of the PCB.

The optical communication device according to an embodiment disclosed herein may further include a second conformal coating layer of a polymer material, coated onto at least a part of a second surface that is different from a first surface contacting the PCB among surfaces of the first conformal coating layer.

In the optical communication device according to an embodiment disclosed herein, the second surface may include a third surface where the first conformal coating layer contacts the first optical element, a fourth surface where the first conformal coating layer contacts the second optical element, and a fifth surface except for the third surface and the fourth surface.

In the optical communication device according to an embodiment disclosed herein, the second conformal coating layer may be configured to contact the entire fifth surface.

In the optical communication device according to an embodiment disclosed herein, a refractive index of the first conformal coating layer may be greater than a refractive index of the PCB and a refractive index of the second conformal coating layer.

### [Advantageous Effects]

According to embodiments disclosed herein, a conformal coating layer of a PCB may perform optical communication between optical elements by using a conformal coating layer of a PCB as an optical waveguide, without adding a separate component (e.g., an optical cable, a connector, etc.).

According to embodiments disclosed herein, optical communication between optical elements where a line of sight (LoS) is not secured may be enabled.

Moreover, various effects recognized directly or indirectly from the disclosure may be provided.

### [DESCRIPTION OF DRAWINGS]

FIG. 1 is a block diagram showing a configuration of an optical communication device according to an embodiment.
FIG. 2 is a view for describing a method where an optical waveguide transmits an optical signal by using total reflection characteristics of light.
FIG. 3 is a plan view showing an arrangement state of a PCB, a first optical element, a second optical element, and a conformal coating layer of an optical communication device, according to an embodiment.
FIGS. 4A and 4B are a plan view and a cross-sectional view showing an arrangement state of a PCB, a first optical element, a second optical element, and a conformal coating layer of an optical communication device, according to an embodiment.
FIG. 5 is a plan view showing an arrangement state of a PCB, a first optical element, a second optical element, a third optical element, and a conformal coating layer of an optical communication device, according to an embodiment.
FIG. 6 is a plan view showing an arrangement state of a PCB, a first optical element, a second optical element, and a conformal coating layer of an optical communication device, according to an embodiment.
FIGS. 7A and 7B are a plan view and a cross-sectional view showing an arrangement state of a PCB, a first optical element, a second optical element, a first conformal coating layer, and a second conformal coating layer of an optical communication device, according to an embodiment.
FIGS. 8A and 8B are a plan view and a cross-sectional view showing an arrangement state of a PCB, a first optical element, a second optical element, a third optical element, a first conformal coating layer, and a second conformal coating layer of an optical communication device, according to an embodiment.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., an element or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., elements or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the element, the program, or another component may be carried out sequentially, in parallel, repeatedly, or heuristically, or one or more of the operations may be executed in a different order or omitted, or one or more other operations may be added.

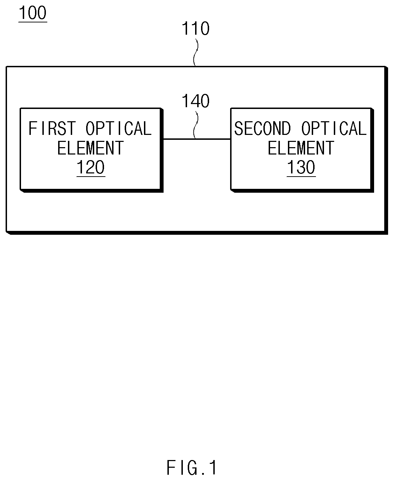

FIG. 1 is a block diagram showing a configuration of an optical communication device according to an embodiment.

Referring to FIG. 1, an optical communication device 100 may include a printed circuit board (PCB) 110, a first optical element 120, a second optical element 130, and an optical waveguide 140.

The PCB 110 may have mounted thereon components of the optical communication device 100 (e.g., the first optical element 120 and/or the second optical element 130). According to an embodiment, the PCB 110 may be a metal-core PCB (MPCB) based on metal having good thermal conductivity. According to another embodiment, the PCB 110 may be based on an insulating substrate material. However, without being limited to these examples, the PCB 110 may be implemented as various types and structures.

The first optical element 120 (or the second optical element 130) may perform optical communication with the second optical element 130 (or the first optical element 120). According to an embodiment, the first optical element 120 and the second optical element 130 may transmit and receive optical signals to and from each other by using an optical waveguide 140. The first optical element 120 (or the second optical element 130) may transmit an optical signal to the second optical element 130 (or the first optical element 120) by using the optical waveguide 140 or receive the optical signal from the second optical element 130 (or the first optical element 120).

The optical waveguide 140 may transmit the optical signal output from the first optical element 120 (or the second optical element 130) to the second optical element 130 (or the first optical element 120). According to an embodiment, the optical waveguide 140 may transmit the optical signal by using total reflection characteristics of light. To this end, the optical waveguide 140 may include a material that allows an optical signal traveling inside the optical waveguide 140 to be totally reflected from a surface of the optical waveguide 140. For example, the optical waveguide 140 may include a material having a greater refractive index than a refractive index of a material contacting the surface thereof. According to an embodiment, the optical waveguide 140 may be implemented using a conformal coating layer of a polymer material coated onto at least a part of a surface of the PCB 110.

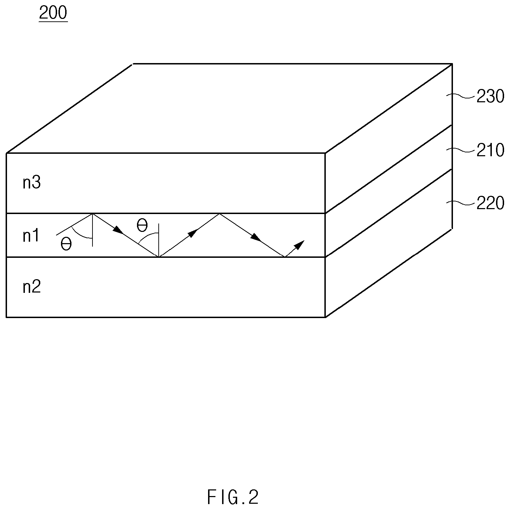

FIG. 2 is a view for describing a method where an optical waveguide transmits an optical signal by using total reflection characteristics of light. FIG. 2 will be described using components of FIG. 1.

Referring to FIG. 2, an optical waveguide module 200 may include a core layer 210, a lower cladding layer 220, and an upper cladding layer 230. According to an embodiment, the core layer 210 may contact the lower cladding layer 220 and the upper cladding layer 230.

According to an embodiment, the optical waveguide module 200 may transmit an optical signal by using characteristics where an optical signal incident to the core layer 210 operating as an optical waveguide (e.g., the optical waveguide 140 of FIG. 1) is totally reflected from a surface of the core layer 210. To this end, the core layer 210 may include a material having a refractive index n1 greater than a refractive index n2 of the lower cladding layer 220 and a refractive index n3 of the upper cladding layer 230.

According to an embodiment, the core layer 210 may be implemented using a conformal coating layer of a polymer material coated onto at least a part of the surface of the PCB 110. In this case, the lower cladding layer 220 is implemented with the PCB 110, but the upper cladding layer 230 may be implemented with air or a conformal coating layer of a material different from that of the core layer 210.

For example, when the surface of the PCB 110 is conformally coated with a single material, the core layer 210 operating as the optical waveguide may be implemented with a conformal coating layer and the upper cladding layer 230 may be implemented with air. In this case, the conformal coating layer may include a material having the refractive index n1 greater than the refractive index n2 of the PCB 110 and the refractive index n3 of air.

In another example, when the surface of the PCB 110 is conformally coated with dual materials, the core layer 210 operating as the optical waveguide may be implemented with a first conformal coating layer and the upper cladding layer 230 may be implemented with a second conformal coating layer including a material that is different from that of the first conformal coating layer. In this case, the first conformal coating layer may include a material having the refractive index n1 greater than the refractive index n2 of the PCB 110 and the refractive index n3 of the second conformal coating layer.

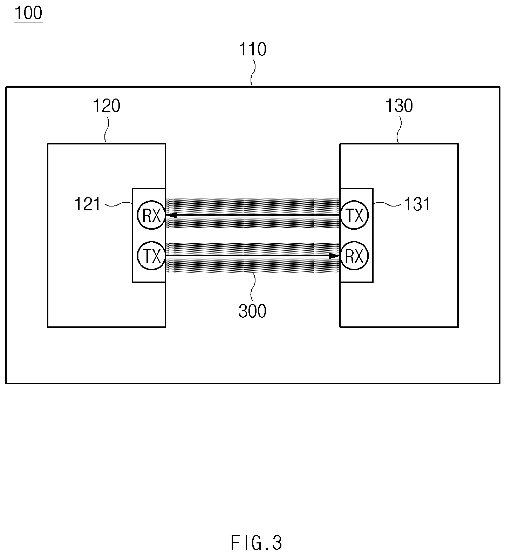

FIG. 3 is a plan view and a cross-sectional view showing an arrangement state of a PCB, a first optical element, a second optical element, and a conformal coating layer of an optical communication device, according to an embodiment.

Referring to FIG. 3, the optical communication device 100 may include the PCB 110, the first optical element 120, the second optical element 130, and a conformal coating layer 300.

The first optical element 120 (or the second optical element 130) may perform an optical signal input/output unit 121 or 131. According to an embodiment, the optical signal input/output unit 121 or 131 may include an optical signal output unit TX for outputting an optical signal and an optical signal input unit RX for receiving an optical signal. According to an embodiment, the first optical element 120 (or the second optical element 130) may output an optical signal through the optical signal output unit TX and receive an optical signal through the optical signal input unit RX.

The conformal coating layer 300 may be coated onto at least a part of the surface of the PCB 110. Herein, the conformal coating layer 300 may be formed of a polymer material.

According to an embodiment, the conformal coating layer 300 may be used as an optical waveguide in optical communication between the first optical element 120 and the second optical element 130. According to an embodiment, the conformal coating layer 300 may transmit the optical signal output from the first optical element 120 (or the second optical element 130) to the second optical element 130 (or the first optical element 120). To this end, the conformal coating layer 300 may contact the optical signal input/output unit 121 or 131 of the first optical element 120 and the second optical element 130. For example, the conformal coating layer 300 may include a first coating layer that contacts the optical signal output unit TX of the first optical element 120 and the optical signal input unit RX of the second optical element 130 and a second coating layer that contacts the optical signal input unit RX of the first optical element 120 and the optical signal output unit TX of the second optical element 130 and does not contact the first coating layer. In another example, the conformal coating layer 300 may include one coating layer that contacts the optical signal input/output unit 121 of the first optical element 120 and the optical signal input/output unit 131 of the second optical element 130.

According to an embodiment, the conformal coating layer 300 may transmit the optical signal by using total reflection characteristics of light. To this end, the conformal coating layer 300 may include a material that allows an optical signal traveling therein to be totally reflected from a surface thereof. For example, the conformal coating layer 300 may include a material having a greater refractive index than a refractive index of a material contacting the surface thereof.

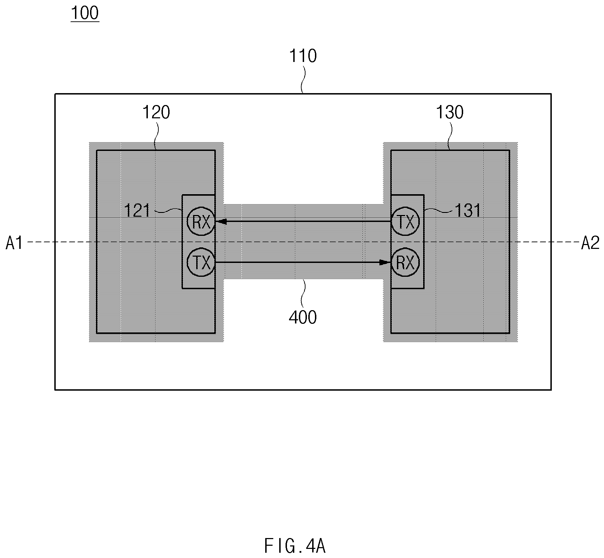

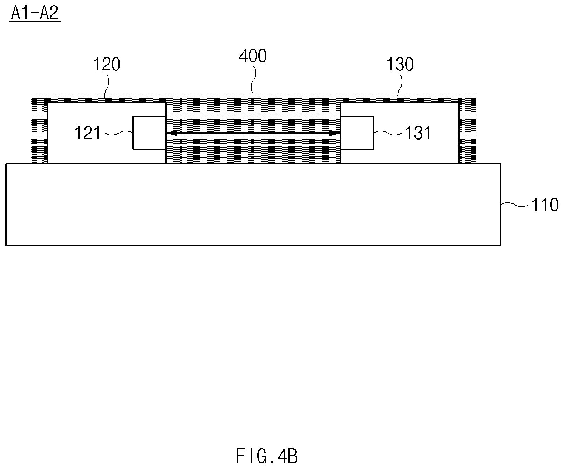

FIGS. 4A and 4B are a plan view and a cross-sectional view showing an arrangement state of a PCB, a first optical element, a second optical element, and a conformal coating layer of an optical communication device, according to an embodiment.

In particular, FIG. 4B is a cross-sectional view cut from a plan view of FIG. 4A along a line A1-A2.

Referring to FIGS. 4A and 4B, the optical communication device 100 may include the PCB 110, the first optical element 120, the second optical element 130, and a conformal coating layer 400.

The first optical element 120 (or the second optical element 130) may perform an optical signal input/output unit 121 or 131. According to an embodiment, the optical signal input/output unit 121 or 131 may include an optical signal output unit TX for outputting an optical signal and an optical signal input unit RX for receiving an optical signal. According to an embodiment, the first optical element 120 (or the second optical element 130) may output an optical signal through the optical signal output unit TX and receive an optical signal through the optical signal input unit RX.

The conformal coating layer 400 may be coated onto at least a part of the surface of the PCB 110, and may be coated onto the entire surface that does not contact the PCB 110 among surfaces of the first optical element 120 and the second optical element 130. Herein, the conformal coating layer 400 may be formed of a polymer material.

According to an embodiment, the conformal coating layer 400 may be used as an optical waveguide in optical communication between the first optical element 120 and the second optical element 130. According to an embodiment, the conformal coating layer 400 may transmit the optical signal output from the first optical element 120 (or the second optical element 130) to the second optical element 130 (or the first optical element 120). To this end, the conformal coating layer 400 may contact the optical signal input/output unit 121 or 131 of the first optical element 120 and the second optical element 130.

According to an embodiment, the conformal coating layer 400 may transmit the optical signal by using total reflection characteristics of light. To this end, the conformal coating layer 400 may include a material that allows an optical signal traveling therein to be totally reflected from a surface thereof. For example, the conformal coating layer 400 may include a material having a greater refractive index than a refractive index of a material contacting the surface thereof.

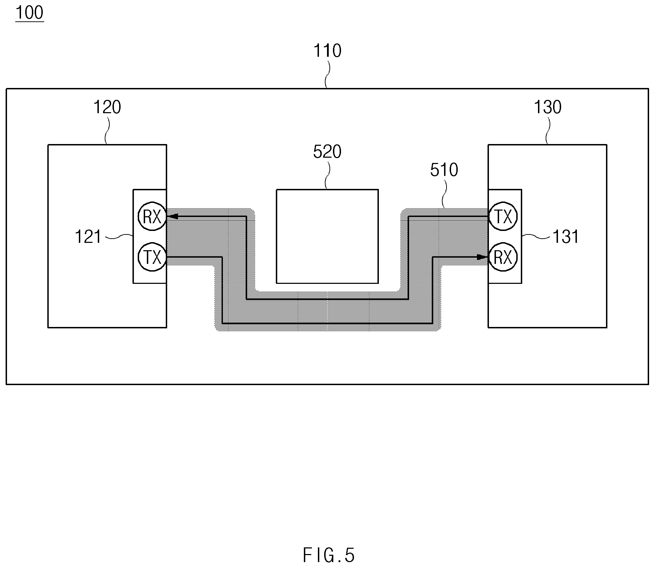

FIG. 5 is a plan view showing an arrangement state of a PCB, a first optical element, a second optical element, a third optical element, and a conformal coating layer of an optical communication device, according to an embodiment.

Referring to FIG. 5, the optical communication device 100 may include the PCB 110, the first optical element 120, the second optical element 130, a third optical element 520, and a conformal coating layer 510.

The first optical element 120 (or the second optical element 130) may perform an optical signal input/output unit 121 or 131. According to an embodiment, the optical signal input/output unit 121 or 131 may include an optical signal output unit TX for outputting an optical signal and an optical signal input unit RX for receiving an optical signal. According to an embodiment, the first optical element 120 (or the second optical element 130) may output an optical signal through the optical signal output unit TX and receive an optical signal through the optical signal input unit RX.

The conformal coating layer 510 may be coated onto at least a part of the surface of the PCB 110. Herein, the conformal coating layer 300 may be formed of a polymer material. According to an embodiment, the conformal coating layer 510 may not contact the third optical element 520 to prevent an optical signal traveling therein from being input to the third optical element 520.

According to an embodiment, the conformal coating layer 510 may be used as an optical waveguide in optical communication between the first optical element 120 and the second optical element 130. According to an embodiment, the conformal coating layer 510 may transmit the optical signal output from the first optical element 120 (or the second optical element 130) to the second optical element 130 (or the first optical element 120). To this end, the conformal coating layer 510 may contact the optical signal input/output unit 121 or 131 of the first optical element 120 and the second optical element 130.

According to an embodiment, the conformal coating layer 510 may transmit the optical signal by using total reflection characteristics of light. To this end, the conformal coating layer 510 may include a material that allows an optical signal traveling therein to be totally reflected from a surface thereof. For example, the conformal coating layer 510 may include a material having a greater refractive index than a refractive index of a material contacting the surface thereof.

According to an embodiment, a corner portion of the conformal coating layer 510 may have a designated curvature such that an optical signal incident from the first optical element 120 (or the second optical element 130) is totally reflected and thus travels to the second optical element 130 (or the first optical element 120).

Referring to FIG. 5, even when an LoS is not secured between optical signal input/output units of the first optical element 120 and the second optical element 130 that transmit and receive optical signals therebetween through optical communication, optical communication may be possible through the conformal coating layer 510 used as an optical waveguide.

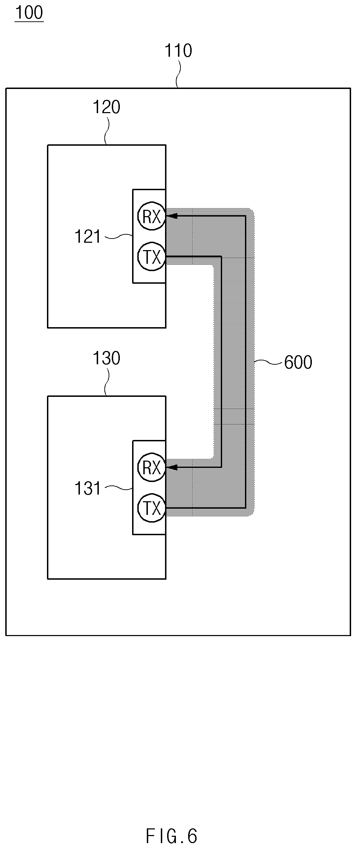

FIG. 6 is a plan view showing an arrangement state of a PCB, a first optical element, a second optical element, and a conformal coating layer of an optical communication device, according to an embodiment.

Referring to FIG. 6, the optical communication device 100 may include the PCB 110, the first optical element 120, the second optical element 130, and a conformal coating layer 600.

The first optical element 120 (or the second optical element 130) may perform an optical signal input/output unit 121 or 131. According to an embodiment, the optical signal input/output unit 121 or 131 may include an optical signal output unit TX for outputting an optical signal and an optical signal input unit RX for receiving an optical signal. According to an embodiment, the first optical element 120 (or the second optical element 130) may output an optical signal through the optical signal output unit TX and receive an optical signal through the optical signal input unit RX.

The conformal coating layer 600 may be coated onto at least a part of the surface of the PCB 110. Herein, the conformal coating layer 600 may be formed of a polymer material.

According to an embodiment, the conformal coating layer 600 may be used as an optical waveguide in optical communication between the first optical element 120 and the second optical element 130. According to an embodiment, the conformal coating layer 600 may transmit the optical signal output from the first optical element 120 (or the second optical element 130) to the second optical element 130 (or the first optical element 120). To this end, the conformal coating layer 600 may contact the optical signal input/output unit 121 or 131 of the first optical element 120 and the second optical element 130.

According to an embodiment, the conformal coating layer 600 may transmit the optical signal by using total reflection characteristics of light. To this end, the conformal coating layer 600 may include a material that allows an optical signal traveling therein to be totally reflected from a surface thereof. For example, the conformal coating layer 600 may include a material having a greater refractive index than a refractive index of a material contacting the surface thereof.

According to an embodiment, a corner portion of the conformal coating layer 600 may have a designated curvature such that an optical signal incident from the first optical element 120 (or the second optical element 130) is totally reflected and thus travels to the second optical element 130 (or the first optical element 120).

Referring to FIG. 6, even when an LoS is not secured between optical signal input/output units of the first optical element 120 and the second optical element 130 that transmit and receive optical signals therebetween through optical communication, optical communication may be possible through the conformal coating layer 600 used as an optical waveguide.

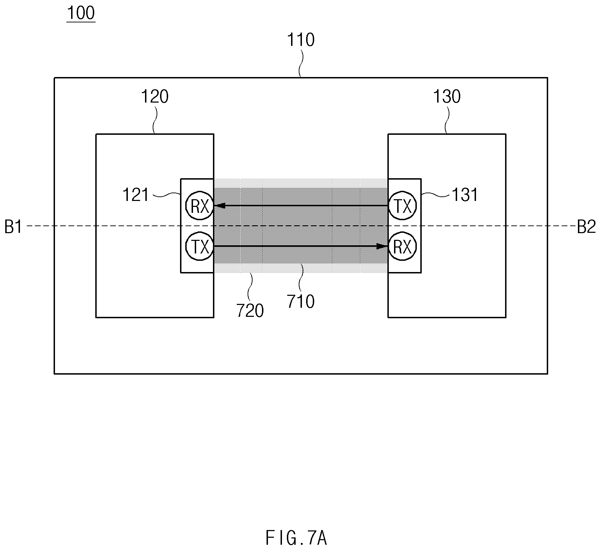

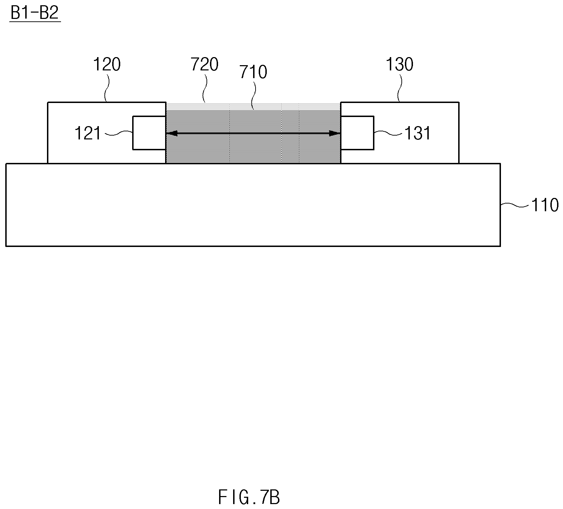

FIGS. 7A and 7B are a plan view and a cross-sectional view showing an arrangement state of a PCB, a first optical element, a second optical element, a first conformal coating layer, and a second conformal coating layer of an optical communication device, according to an embodiment.

In particular, FIG. 7B is a cross-sectional view cut from a plan view of FIG. 7A along a line B1-B2.

Referring to FIGS. 7A and 7B, the optical communication device 100 may include the PCB 110, the first optical element 120, the second optical element 130, a first conformal coating layer 710, and a second conformal coating layer 720.

The first optical element 120 (or the second optical element 130) may perform an optical signal input/output unit 121 or 131. According to an embodiment, the optical signal input/output unit 121 or 131 may include an optical signal output unit TX for outputting an optical signal and an optical signal input unit RX for receiving an optical signal. According to an embodiment, the first optical element 120 (or the second optical element 130) may output an optical signal through the optical signal output unit TX and receive an optical signal through the optical signal input unit RX.

The first conformal coating layer 710 may be coated onto at least a part of the surface of the PCB 110. Herein, the first conformal coating layer 710 may be formed of a polymer material.

According to an embodiment, the first conformal coating layer 710 may be used as an optical waveguide in optical communication between the first optical element 120 and the second optical element 130. According to an embodiment, the first conformal coating layer 710 may transmit the optical signal output from the first optical element 120 (or the second optical element 130) to the second optical element 130 (or the first optical element 120). To this end, the first conformal coating layer 710 may contact the optical signal input/output unit 121 or 131 of the first optical element 120 and the second optical element 130.

According to an embodiment, the first conformal coating layer 710 may transmit the optical signal by using total reflection characteristics of light. To this end, the first conformal coating layer 710 may include a material that allows an optical signal traveling therein to be totally reflected from a surface thereof. For example, the first conformal coating layer 710 may include a material having a greater refractive index than a refractive index of a material contacting the surface thereof.

According to an embodiment, the second conformal coating layer 720 may be coated onto at least a part of a second surface that is different from a first surface contacting the PCB 110 among the surfaces of the first conformal coating layer 710. Herein, the second conformal coating layer 720 may be formed of a polymer material.

Referring to FIGS. 7A and 7B, the second surface of the first conformal coating layer 710 may include a third surface contacting the first optical element 120, a fourth surface contacting the second optical element 130, and a fifth surface except for the third surface and the fourth surface. According to an embodiment, the second conformal coating layer 720 may be coated onto the entire fifth surface of the second surface of the first conformal coating layer 710. In this case, the first conformal coating layer 710 may include a material having a greater refractive index than a refractive index of the PCB 110 contacting the surface thereof and a refractive index of the second conformal coating layer 720.

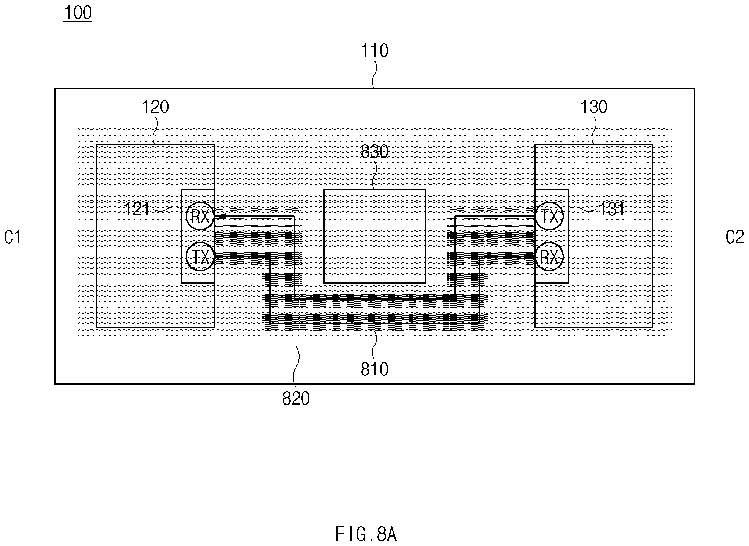

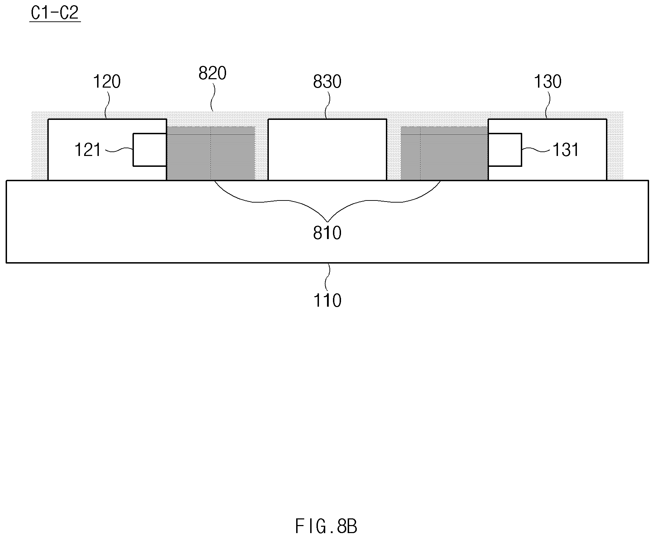

FIGS. 8A and 8B are a plan view and a cross-sectional view showing an arrangement state of a PCB, a first optical element, a second optical element, a third optical element, a first conformal coating layer, and a second conformal coating layer of an optical communication device, according to an embodiment.

In particular, FIG. 8B is a cross-sectional view cut from a plan view of FIG. 8A along a line C1-C2.

Referring to FIGS. 8A and 8B, the optical communication device 100 may include the PCB 110, the first optical element 120, the second optical element 130, a third optical element 830, a first conformal coating layer 810, and a second conformal coating layer 820.

The first optical element 120 (or the second optical element 130) may perform an optical signal input/output unit 121 or 131. According to an embodiment, the optical signal input/output unit 121 or 131 may include an optical signal output unit TX for outputting an optical signal and an optical signal input unit RX for receiving an optical signal. According to an embodiment, the first optical element 120 (or the second optical element 130) may output an optical signal through the optical signal output unit TX and receive an optical signal through the optical signal input unit RX.

The first conformal coating layer 810 may be coated onto at least a part of the surface of the PCB 110. Herein, the first conformal coating layer 810 may be formed of a polymer material. According to an embodiment, the first conformal coating layer 810 may not contact the third optical element 830 to prevent an optical signal traveling therein from being input to the third optical element 830.

According to an embodiment, the first conformal coating layer 810 may be used as an optical waveguide in optical communication between the first optical element 120 and the second optical element 130. According to an embodiment, the first conformal coating layer 810 may transmit the optical signal output from the first optical element 120 (or the second optical element 130) to the second optical element 130 (or the first optical element 120). To this end, the first conformal coating layer 810 may contact the optical signal input/output units 121 and 131 of the first optical element 120 and the second optical element 130.

According to an embodiment, the first conformal coating layer 810 may transmit the optical signal by using total reflection characteristics of light. To this end, the first conformal coating layer 810 may include a material that allows an optical signal traveling therein to be totally reflected from a surface thereof. For example, the first conformal coating layer 810 may include a material having a greater refractive index than a refractive index of a material contacting the surface thereof.

According to an embodiment, a corner portion of the first conformal coating layer 810 may have a designated curvature such that an optical signal incident from the first optical element 120 (or the second optical element 130) is totally reflected and thus travels to the second optical element 130 (or the first optical element 120).

According to an embodiment, the second conformal coating layer 820 may be coated onto at least a part of a second surface that is different from a first surface contacting the PCB 110 among the surfaces of the first conformal coating layer 810. Herein, the second conformal coating layer 820 may be formed of a polymer material.

Referring to FIGS. 8A and 8B, the second surface of the first conformal coating layer 810 may include a third surface contacting the first optical element 120, a fourth surface contacting the second optical element 130, and a fifth surface except for the third surface and the fourth surface. According to an embodiment, the second conformal coating layer 820 may be coated onto the entire fifth surface of the second surface of the first conformal coating layer 810. In this case, the first conformal coating layer 810 may include a material having a greater refractive index than a refractive index of the PCB 110 contacting the surface thereof and a refractive index of the second conformal coating layer 820.

Referring to FIGS. 8A and 8B, even when an LoS is not secured between optical signal input/output units of the first optical element 120 and the second optical element 130 that transmit and receive optical signals therebetween through optical communication, optical communication may be possible through the first conformal coating layer 810 used as an optical waveguide.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. An optical communication device comprising:
a first optical element;
a second optical element configured to perform optical communication with the first optical element;
a printed circuit board (PCB) where the first optical element and the second optical element are arranged; and
a first conformal coating layer of a polymer material, coated onto at least a part of a surface of the PCB,
wherein the optical communication is performed using the first conformal coating layer as an optical waveguide.

2. The optical communication device of claim 1, wherein the first conformal coating layer is configured to contact an optical signal input/output unit of the first optical element and an optical signal input/output unit of the second optical element.

3. The optical communication device of claim 1, wherein the first conformal coating layer is configured to avoid contacting optical elements other than the first optical element and the second optical element among a plurality of optical elements arranged on the PCB.

4. The optical communication device of claim 1, wherein the first conformal coating layer comprises a material that allows an optical signal traveling inside the first conformal coating layer to totally reflect from a surface of the first conformal coating layer.

5. The optical communication device of claim 4, wherein a refractive index of the first conformal coating layer is greater than a refractive index of the PCB.

6. The optical communication device of claim 1, further comprising a second conformal coating layer of a polymer material, coated onto at least a part of a second surface that is different from a first surface contacting the PCB among surfaces of the first conformal coating layer.

7. The optical communication device of claim 6, wherein the second surface comprises a third surface where the first conformal coating layer contacts the first optical element, a fourth surface where the first conformal coating layer contacts the second optical element, and a fifth surface that is not the third surface and the fourth surface.

8. The optical communication device of claim 7, wherein the second conformal coating layer is configured to contact an entirety of the fifth surface.

9. The optical communication device of claim 6, wherein a refractive index of the first conformal coating layer is greater than a refractive index of the PCB and a refractive index of the second conformal coating layer.
